# EUROPÄISCHE PATENTSCHRIFT

(11) **EP 1 319 254 B1**
(45) Veröffentlichungstag und Bekanntmachung des Hinweises auf die Patenterteilung: **12.07.2006**
(21) Anmeldenummer: 01971984.8
(22) Anmeldetag: 30.08.2001
(51) Int. Cl.: H01L 31/0224, H01L 31/18

(54) **Verfahren zur Herstellung eines Halbleiter-Metallkontaktes durch eine dielektrische Schicht**
Method for producing a semiconductor-metal contact through a dielectric layer
Procédé de réalisation d'un contact semi-conducteur-metal par l'intermédiaire d'une couche diélectrique

(30) Priorität: 19.09.2000 DE 10046170
(43) Veröffentlichungstag der Anmeldung: 18.06.2003
(73) Patentinhaber: Fraunhofer-Gesellschaft zur Förderung der angewandten Forschung e.V., 80686 München (DE)
(72) Erfinder: PREU, Ralf, 79102 Freiburg (DE); SCHNEIDERLÖCHNER, Eric, 79100 Freiburg (DE); GLUNZ, Stefan, 79098 Freiburg (DE); LÜDEMANN, Ralf, 79100 Freiburg (DE)
(74) Vertreter: Rösler, Uwe
(86) Internationale Anmeldenummer: PCT/EP2001/010029
(87) Internationale Veröffentlichungsnummer: WO 2002/025742

(56) Entgegenhaltungen:
- EP-A- 0 251 523
- WO-A-00/01019
- WO-A-00/22681
- US-A- 5 011 565
- US-A- 5 183 780
- J.E. COTTER ET AL.: "Novel processes for simplified buried contact solar cells" CONFERENCE RECORD OF THE 28TH IEEE PHOTOVOLTAIC SPECIALISTS CONFERENCE, 15. - 22. September 2000, Seiten 303-306, XP002200820 Anchorage, Alaska
- F. DUERINCKX ET AL.: "Simple and efficient screen printing process for multicrystalline silicon solar cells based on firing through silicon nitride" 14TH EUROPEAN PHOTOVOLTAIC SOLAR ENERGY CONFERENCE, Bd. i, 30. Juni 1997 (1997-06-30) - 4. Juli 1997 (1997-07-04), Seiten 792-795, XP002200821 Barcelona, Spain
- R. PREU ET AL.: "Laser ablation- A new low-cost approach for passivated rear contact formation in crystalline silicon solar cell technology" 16TH EUROPEAN PHOTOVOLTAIC SOLAR ENERGY CONFERENCE, Bd. II, 1. - 5. Mai 2000, Seiten 1181-1184, XP002200822 Glasgow, UK in der Anmeldung erwähnt

## Beschreibung

### Technisches Gebiet

Die Erfindung bezieht sich auf ein Verfahren zur elektrischen Kontaktierung einer mit wenigstens einer dielektrischen Schicht überzogenen, elektrisch zu kontaktierenden Halbleiteroberfläche, insbesondere zur Kontaktierung der p-leitenden Basisschicht einer Solarzelle, die mit einer dielektrischen Passivierungsschicht überzogen ist.

### Stand der Technik

Die industrielle Fertigung von Solarzellen unterliegt bereits rein aus Wettbewerbsgründen den Bestrebungen, Solarzellen mit möglichst hohem Wirkungsgrad, d.h. einer möglichst hohen elektrischen Stromausbeute aus dem auf die Solarzelle eintreffenden solaren Energiefluß, herzustellen und zugleich den Fertigungsaufwand und damit eng verbunden die Herstellungskosten gering zu halten.

Zum näheren Verständnis der bei einer optimierten Fertigung von Solarzellen zu beachtenden Maßnahmen sollen die nachstehenden Ausführungen dienen:

Solarzellen sind Bauelemente, die Licht in elektrische Energie umwandeln. Üblicherweise bestehen sie aus einem Halbleitermaterial - meist werden Solarzellen aus Silizium gefertigt -, das n- bzw. p-dotierte Halbleiterbereiche aufweist. Die Halbleiterbereiche werden in an sich bekannter Weise als Emitter bzw. Basis bezeichnet. Durch auf die Solarzelle einfallendes Licht werden innerhalb der Solarzelle positive und negative Ladungsträger erzeugt, die an der Grenzfläche zwischen dem n- (Emitter) und p-dotierten (Basis) Halbleiterbereich, am sogenannten pn-Übergang räumlich voneinander getrennt werden. Mittels metallischer Kontakte, die mit dem Emitter und mit der Basis verbunden sind, können diese voneinander getrennten Ladungsträger abgeführt werden.

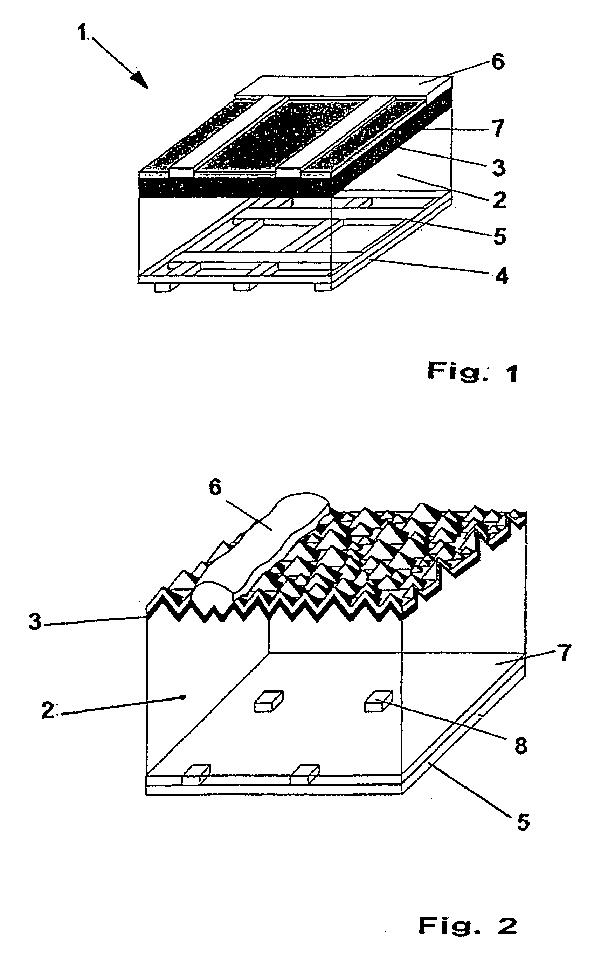

In der einfachsten Form bestehen Solarzellen aus ganzflächigen Basis- 2 und Emitterbereichen 3, wobei der Emitter 3 auf der dem Licht zugewandten Seite, der Vorderseite der Solarzelle liegt. Zur Veranschaulichung sei an dieser Stelle auf Figur 1 verwiesen, die eine bekannte Solarzelle 1 zeigt.

Zur elektrischen Kontaktierung der Basis 2 wird für gewöhnlich die Rückseite der Solarzelle 1 mit einer ganzflächigen Metallschicht 4 versehen, auf die geeignete Rückseitenkontaktleiterbahnen 5, bspw. aus AlAg aufgebracht sind. Der Emitterbereich 3 wird mit einem Metall-Grid 6 kontaktiert mit dem Ziel, möglichst wenig Licht durch Reflexion am Metallkontakt für die Solarzelle zu verlieren, d.h. das Metall-Grid 6 weist eine Fingerstruktur auf, um möglichst wenig Solarzellenfläche zu verdecken. Zur Optimierung der Leistungsausbeute der Solarzelle 1 wird zudem versucht die optischen Verluste auf Grund von Reflexion möglichst klein zu halten. Erreicht wird dies durch die Abscheidung sogenannter Antireflexionsschichten 7 (ARC) auf der Vorderseitenoberfläche der Solarzelle 1. Die Schichtdicke der Antireflexionsschichten 7 ist so gewählt, dass sich im energetisch wichtigsten Spektralbereich gerade destruktive Interferenz des reflektierten Lichtes ergibt. Verwendete Antireflexmaterialien sind z.B. Titandioxid, Siliciumnitrid und Siliciumdioxid. Altemativ oder zusätzlich hierzu kann eine Reflexionsminderung durch Herstellung einer geeigneten Oberfächentextur mittels einem Ätz- oder mechanischen Bearbeitungsverfahren erzielt werden, wie es auch aus der in Figur 2 dargestellten Solarzelle hervorgeht. Hier ist der Emitterbereich 3 sowie auch die auf dem Emitter aufgebrachte Antireflexionsschicht 7 derart strukturiert ausgebildet, dass das auf die strukturierte Oberfläche der Solarzelle 1 einfallende Licht an den pyramidenartig ausgebildeten Strukturen eine erhöhte Einkopplungswahrscheinlichkeit hat. Auch im Falle der Solarzelle gemäß der Figur 2 erfolgt die elektrische Kontaktierung des Emitters 3 mit einem möglichst feingliedrigen Metall-Grid 6, von dem lediglich ein schmaler Kontaktfinger in Figur 2 dargestellt ist. Die Antireflexionsschicht 7 auf der Vorderseite kann überdies auch als Passivierungsschicht dienen, die zum einen für einen mechanischen Oberflächenschutz sorgt aber zudem auch intrinsische Wirkungen besitzt hinsichtlich der Reduzierung von Oberflächenrekombinationsprozessen, auf die im weiteren genauer eingegangen wird.

Bei der elektrischen Kontaktierung einer Solarzelle ist zwischen der Vorder- und Rückseite zu unterscheiden. Während auf der Rückseite der Solarzelle versucht wird, einen Kontakt herzustellen, der sich hauptsächlich durch einen niedrigen Kontakt- und Leitungswiderstand auszeichnet, muß auf der Vorderseite zusätzlich möglichst viel Licht in die Solarzeile eingekoppelt werden. Deshalb wird auf der Vorderseite normalerweise eine Kammstruktur, wie aus der Figur 1 ersichtlich, erzeugt, um sowohl die Widerstands- als auch die Abschattungsverluste klein zu halten. Auf der Rückseite der Solarzelle kommen für gewöhnlich sowohl ganzflächige als auch strukturierte z.B. gitterartige Kontakte zum Einsatz.

Die Oberflächen von Solarzellen hoher Wirkungsgrade zeichnen sich neben guten elektrischen Kontaktierungen zusätzlich durch eine niedrige Oberflächenrekombinationsgeschwindigkeit aus, d.h. die Wahrscheinlichkeit, dass Minoritätsladungsträger an die Oberfläche der Solarzelle gelangen und dort rekombinieren und somit nicht zur Energieerzeugung beitragen, wodurch es zu einer erheblichen Wirkungsgradreduktion kommt, ist gering.

Realisiert werden kann dies entweder dadurch, dass a) wenige Minoritätsladungsträger an die Oberfläche gelangen, oder dass b) sie an der Oberfläche nur mit geringer Wahrscheinlichkeit rekombinieren.

Die Methode a) kann dadurch realisiert werden, indem im Bereich der Oberfläche eine hohe Dotierung an Fremdatomen erzeugt wird oder dass auf die Oberfläche eine dielektrische Schicht aufgebracht wird und feste Ladungen in der Grenzebene zwischen Halbleiter und dielektrischer Schicht eingebaut werden. Eine hohe Dotierung ist durch die Emitterdotierung auf der Vorderseite in verschieden starker Ausprägung realisiert, auf der Rückseite kann hierzu unterstützend ein Rückseitenfeld, ein sogenanntes "Back Surface Field" eingebaut werden.

Eine hohe Dotierung ist jedoch stets mit dem Nachteil verbunden, dass zwar die Rekombinationswahrscheinlichkeit an den Oberflächen der Solarzelle reduziert werden kann, dafür efiöht sich jedoch die Rekombinationswahrscheinlichkeit innerhalb der Solarzellenschicht. Ladungen können z.B. auch durch eine Schicht aus Siliciumnitrid, die besonders gut als Antireflexionsschicht dient, eingebaut werden.

Die Methode b) kann dadurch realisiert werden, dass die Oberflächenrekombinationszustände verringert werden, z.B. dadurch, dass an der Oberfläche aufgebrochene und somit nicht abgesättigte Siliziumbindungen durch eine Schicht aus Siliziumnitrid oder Silizumdioxid abgesättigt werden die, wie oben beschrieben, an der Vorderseite auch als Antireflexschicht verwendet werden können. Diese Passivierung kann sowohl an der Vorder- als auch an der Rückseite angewendet werden und ist eines der wichtigsten Merkmale hocheffizienter Solarzellen.

Ein weiteres Merkmal derartiger hocheffizienter Solarzellen sind schmale (<40µm) und hohe Vorderseitenkontakte (>10 µm) mit niedrigem Kontakt- und Leitungswiderstand. Die als Grid-Finger ausgebildeten Oberflächenkontakte sollen möglichst wenig Solarzellenfläche abdecken, also müssen sie möglichst schmal ausgebildet sein. Überdies sollen die Grid-Finger für die Abführung der in der Solarzelle getrennten Ladungsträger einen möglichst geringen Leitungswiderstand aufweisen, also sollte ihr Leitungsquerschnitt möglichst groß sein.

Die wichtigsten bekannten Metallisierungstechnologien für die Rückseitenkontakte einer Solarzelle sind:
A. Siebdruckverfahren
   Per Siebdruck wird eine Aluminiumpaste ganzflächig auf die Oberfläche gedruckt. Anschließend wird bei einem Hochtemperaturschritt für ca. 10-30 Sekunden eine Temperatur von ca. 700-800°C gehalten. Hierdurch wird ein guter elektrischer Kontakt realisiert und es bildet sich eine Aluminiumsiliciumlegierung, das 'Back Surface Field' aus. Dies ist der in der Industrie am weitesten verbreitete Prozeß zur Rückseitenkontaktierung.
B) Ganzflächiges Aufdampfen
   Die Metallschicht wird durch ganzflächiges Aufdampfen aufgebracht.
C) Photolithographie und Aufdampfen
   Zuerst wird eine meist passivierende, dielektrische Schicht z.B. Siliciumdioxid aufgebracht. Durch Belichtung, Entwicklung und Auswaschen eines photosensiblen Filmes, dem sogenannten Ätzresist wird die gewünschte Struktur bis zur vorher aufgebrachten dielektrischen Schicht freigelegt. Durch anschließendes Ätzen wird letztere bis zum Siliziumwafer geöffnet. Auf der Rückseite der Solarzelle kann die Metallisierung sofort nach der Schichtöffnung und dem Entfernen des photosensiblen Ätzresist erfolgen. Der Rückseitenkontakt kann dann ganzflächig, bspw. durch Aufdampfen, aufgebracht werden.
   Mit den bekannten photolithographischen Verfahren können Strukturgrößen bis unter 1 µm hergestellt werden. Die Photolithographie ist aber ein verhältnismäßig kostenaufwendiges Verfahren und wird deshalb kaum im industriellen Bereich der Solarzellenfertigung angewendet. Die meisten Prozesse mit denen bisher Solarzellen mit einem Wirkungsgrad über 20% hergestellt werden enthalten mehrere photolithographische Prozeßschritte. Die bereits unter Bezugnahme auf Figur 2 beschriebene Solarzelle kann mit den beiden vorstehend beschriebenen Photolithographieschritten hergestellt werden.
D) Photolithographie, lokale Hochdotierung und Aufdampfen
   Eine Variante dieses Verfahrens ist die Verwendung einer lokalen Hochdotierung unter den Kontakten, wodurch insbesondere die Kontakteigenschaften verbessert werden. Die bekannte Realisierung der lokalen Hochdotierung wird durch Diffusion eines vor der Diffusion aufzubringenden und anschließend evtl. wieder zu entfernenden Dotierstoffes erreicht. Schliesslich erfolgt die Kontaktierung wie oben, unter (C) beschrieben.
   Unter Anwendung dieses Verfahren sind die höchsten bisher auf Silicium erreichten Wirkungsgrade von ca. 24% realisiert worden. Die Prozessfolge ist aber äußerst aufwendig und komplex und wird deshalb nicht für die Herstellung von Solarzellen in industriellem Maßstab in Betracht gezogen.
E) Ein Verfahren, mit dem auf einer teilweise der Photolithographie ähnlichen Weise der Vorderseitenkontakt einer Solarzelle hergestellt werden kann, ist in US Patent Nr. 5,011,565 "Dotted contact solar cell and method of making same" von Dube et al. dargestellt worden. Das Patent beschreibt einen Solarzellentyp und ein Verfahren zu dessen Herstellung. Die Vorderseite der Solarzelle ist dabei mit einer dielektrischen Schicht versehen die mit einem Laser, insbesondere einem YAG-Laser mit in Linien angeordneten Punkten geöffnet wird. Die Punkte sind mit einem gewissen Abstand angebracht. Die eigentliche Kontaktformierung geschieht dann durch eine Abscheidung von Nickel und Kupfer in einem chemischen Bad. Dabei werden die Abstände zwischen den Punktkontakten überbrückt.
F) Eine ähnliche Kontaktierungsmethode ist in US Patent Nr. 4,626,613 beschrieben. Hier werden zur Kontaktierung durch eine passivierende, dielektrische Schicht hindurch Gräben in die Solarzellenoberfläche eingebracht, die anschließend mit einem Kontaktmetall gefüllt werden. Der Graben wird durch mechanische Strukturierung oder vorzugsweise durch Laserablation hergestellt. Das Verfahren wird industriell zur Kontaktierung der Zellvorderseite eingesetzt.
G) In der Druckschrift WO 0022681 wird ein auf Diffusion aus einer Halbleiterschicht basierendes Kontaktierungsverfahren beschrieben, bei dem mit Hilfe eines beliebig hohen Energieeintrags mittels einer Laserquelle eine Metallschicht durch eine elektrisch isolierende Zwischenschicht und eine niedrig dotierte Halbleiterschicht hindurch mit einer zweiten mit entgegengesetzter Polarität hochdotierten elektrisch leitenden Halbleiterschicht kontaktiert wird. Durch die hohe eingebrachte Lichtenergie setzt eine Diffusion aus der aufgrund ihrer Hochdotierung einfach zu kontaktierenden Halbleiterschicht ein. Eine aus Glasmaterial dienende Substratschicht auf, der die Halbleiterschichtenabfolge aufgebracht ist, dient zum einen als Träger zum anderen als thermische Begrenzungsschicht, die seitens des Laserstrahls nicht aufgeschmolzen werden kann. Insofern spielt eine Dosierung des thermischen Energieeintrages keine oder nur eine untergeordnete Rolle, zumal es gilt, die Halbleiterschichtenabfolge in ihrer gesamten Tiefe auf zu schmelzen.
H) Ein weiteres ähnliches Verfahren ist zur Kontaktierung der Rückseite aus "R. Preu, S. W. Glunz, S. Schäfer, R. Lüdemann, W. Wettling, W. Pfleging, ,Laser Ablation - A New Low-Cost Approach for Passivated Rear Contact Formation in Crystalline Silicon Solar Cell Technology', Proceedings of the 16th European Photovoltaic Solar Energy Conference, Glasgow, UK (2000)" bekannt. Hier wird die Rückseite einer Solarzelle kontaktiert, in dem zuerst eine ganzflächige, passivierende dielektrische Schicht aufgebracht wird und diese anschließend mit einem kurzpulsigen Laser lokal geöffnet wird. Anschliessend wird ganzflächig eine Schicht aus Aluminium aufgebracht. Ein guter elektrischer Kontakt wird durch das Erhitzen der Scheibe auf 400°C oder darüber hergestellt.
1) Ausserdem ist ein Verfahren bekannt, bei dem ganzflächig eine dielektrische Schicht aufgebracht wird und anschliessend lokal eine Paste - z.B. im Siebdruckverfahren - aufgebracht wird, die neben metallischen Bestandteile unter anderem auch ätzende Bestandteile enthält. Bei Erhöhung der Temperatur wird dieser Ätzvorgang in Gang gesetzt oder beschleunigt, so dass die dielektrische Schicht lokal geöffnet wird und sich ein guter elektrischer Kontakt zwischen metallhaltiger Paste und dem Substrat ausbilden kann.

Die heute industriell mit den vorstehend kurz umrissenen Technologien des ganzflächigen Siebdruckes einer Aluminiumpaste (A), sowie des ganzflächigen Aufdampfens (B) hergestellten Solarzellen weisen einen Wirkungsgrad auf, der deutlich unter dem, der mit der Technologie der Photolithographie hergestellten Solarzellen liegt. Ein höherer Wirkungsgrad bedeutet aber einen deutlichen Mehrwert der Solarzelle. Die Anwendung der mittels Photolithographie durchgeführten Technologie (C) und (D) ist jedoch im Augenblick so aufwendig, dass sie trotz der hohen erzielbaren Wirkungsgrade nicht realisiert wird.

Bei den in US 5,011,565 und US 4,626,613 beschriebenen Verfahren wird während der Entfernung der dielektrischen Schicht, das daruntertiegende Silicium so beschädigt, dass in der Praxis ein Teil des Siliciummaterials mit einem zusätzlichen Ätzschritt abgetragen werden muß.

Außerdem tritt bei der Laserablation häufig das Problem auf, dass sich das vom Laserstrahl ablatierte Material auf der zu bearbeitenden Oberfläche absetzt sowie sich auf gegebenenfalls im Lichtstrahl vorhandene optische Abbildungseinheiten, wie Sammellinsen, absetzt, wodurch der Abtrageprozess erheblich in Mitleidenschaft gezogen wird. Unterbrechungen des Abtrageprozesses sind die Folge, um notwendige Reinigungsarbeiten durchführen zu können.

Ähnliche Probleme die Reinigung betreffend stellen sich beim Verfahren (G) ein, vor allem ist hier jedoch die durch das Aufschmelzen des gesamten unterhalb der Lasereinwirkung liegenden Bereichs hervorgerufene Schädigung besonders der dielektrischen Schicht nicht für die Umsetzung von hocheffizienten Solarzellenkonzepten geeignet. Überdies stellt das bekannte Verfahren lediglich eine Möglichkeit zur Kontaktierung von hochdotierter Halbleiterschichten dar.

Schließlich muß zur Erzielung sehr guter Widerstandswerte bei dem Laserablationsverfahren (H) nach dem Aufbringen der Metallschicht im allgemeinen der Kontakt bei Temperaturen über 300°C nachbehandelt werden, was einen zusätzlichen Prozessschritt bedeutet, der zudem die Wahl der dielektrischen Passivierungsschichten einschränkt.

Das lokale Aufbringen der Metall- und ätzhaltigen Paste entsprechend Verfahren (I) hat den Nachteil, dass die Herstellung der Paste aufwendig ist und deshalb deutlich höhere Kosten verursacht als die Verwendung reinen Metalls wie es z.B. beim Aufdampfen verwendet werden kann. Außerdem ist vor der Metallisierung eine Reinigung der Oberfläche notwendig. Darüber hinaus wird bei dem Kontaktformierungsprozeß die Rückseite ganzflächig hohen Temperaturen ausgesetzt, was die Wahl der möglichen Passivierungsmaterialien einschränkt, bzw. eine Verschlechterung der Passivierungsschicht zur Folge haben kann.
Außerdem ist bei nur lokaler Metallisierung der Rückseite z.B. in Form eines Gitters, die Reflektivität der Rückseite zur Erhöhung des zellinternen Lichteinfangs im Vergleich zu einer ganzflächigen Metallisierung heruntergesetzt. Deshalb wird Licht mit einer Wellenlänge, die nur geringfügig im photovoltaisch aktiven Material absorbiert wird, wesentlich schlechter reflektiert als bei einer ganzflächigen metallischen Rückseite.

### Darstellung der Erfindung

Der Erfindung liegt die Aufgabe zugrunde ein Verfahren zur elektrischen Kontaktierung einer mit wenigstens einer dielektrischen Schicht überzogenen, elektrisch zu kontaktierenden Oberfläche, insbesondere zur Kontaktierung der Basisschicht einer Solarzelle, die mit einer dielektrischen Passivierungsschicht überzogen ist, derart weiterzubilden, dass die vorstehend dargelegten, beim Stand der Technik auftretenden Nachteile umgangen werden können. Insbesondere sollte eine Fertigung leistungsfähiger Solarzellen im industriellen Maßstab möglich sein, die zum einen den hohen Ansprüchen der Erzielung guter Wirkungsgrade gerecht wird, als auch zum anderen eine möglichst preisgünstige Produktion der Solarzellen begünstigt. Überhitzungen der nicht zu kontaktierenden Materialbereiche, eine Schädigung des zu kontaktierenden Halbleitermaterials oder der den Kontaktbereich umgebenden dielektrischen Schicht, sowie eine Verunreinigung während des Kontaktierens sollten vollständig vermieden werden. Weiterhin gilt es die aufgrund eines zu hohen Wärmeeintrags in die Halbleiterschicht normalerweise auftretende Diffusion von Dotieratomen aus eventuell angrenzenden dotierten Halbleiterschichten, beispielsweise aus dem Solarzellenemitter in das zu kontaktierende Basismaterial oder umgekehrt, unbedingt zu vermeiden.

Die Lösung der der Erfindung zugrunde liegenden Aufgabe ist im Anspruch 1 angegeben. Den Erfindungsgedanken vorteilhaft ausbildende Merkmale sind Gegenstand der Unteransprüche.

Erfindungsgemäß ist das Verfahren zur elektrischen Kontaktierung einer mit wenigstens einer passivierenden dielektrischen Schicht überzogenen, elektrisch zu kontaktierenden Halbleiterschicht, - insbesondere zur Kontaktierung der Basisschicht einer durch einen pn-Übergang ausgebildeten Solarzelle, die mit einer dielektrischen Passivierungsschicht überzogen ist -, derart weitergebildet, dass die Passivierungsschicht vorzugsweise ganzflächig mit einer Metallschicht - vorzugsweise eine Aluminiumschicht - bedeckt wird und der Kontakt durch kurzzeitiges lokales Aufschmelzen ausschließlich der Metallschicht, der dielektrischen Schicht sowie der Halbleiterschicht mit einer Laserstrahlungsquelle hergestellt wird. Durch den lokal eng begrenzten Aufschmelzvorgang der Aluminiumschicht und der zwischen Aluminiumschicht und der Halbleiterschicht befindlichen dielektrischen Schicht, sowie der Oberfläche der Halbleiterschicht bildet sich zwischen den einzelnen Schichten eine Schmelzmischung aus, die nach dem Erstarren einen elektrischen Kontakt zwischen dem Halbleiter und der Metallschicht bildet. Hierbei wird der Schichtverbund nur unmittelbar am Ort des Kontaktes derart modifiziert, dass auf diese Weise ein hinreichend niedriger spezifischer Kontaktwiderstand zwischen Metallschicht und dotierter Halbleiterschicht für die Herstellung hocheffizienter Solarzellen gewonnen werden kann. Insbesondere kommt es also darauf an, dass der Energieeintrag derart geregelt wird, dass an dem lokalen Kontakt ein hinreichend niedriger spezifischer Kontaktwiderstand erreicht wird, wobei darauf zu achten ist, dass in der Umgebung des lokalen Kontaktes der Schichtverbund, insbesondere die Passivierungswirkung der dielektrischen Schicht, in ihren Eigenschaften möglichst nicht beeinflußt wird und keine Diffusion aus angrenzenden Halbleiterschichten einsetzt.

Der Erfindung liegt die Idee zugrunde durch die Passivierungsschicht, die eine Schichdicke von weniger 1 µm auweist, vorzugsweise 10 nm bis 500 nm dick ist, hindurch, ein bestimmtes Muster oder eine bestimmte Anordnung von Kontaktstellen zu schaffen, an denen die zu kontaktierende Materialoberfläche, vorzugsweise die Emitter und/oder Basisschicht der Solarzelle, sich mit der Metallschicht, vorzugsweise Aluminium, elektrisch leitend verbindet, ohne eventuell angrenzende Schichten zu modifizieren. Die Metallschicht weist dabei eine Schichtdicke von ca. 2 µm auf. Die lokale Erhitzung von Aluminium- und Passivierungsschicht sowie der Halbleiteroberfläche erfolgt durch Laserbestrahlung, d.h. durch unmittelbare Laserlichteinwirkung auf die Oberfläche des Aluminiums wird dieses lokal derart stark erhitzt, dass ein Schmelzgemisch aus dem Aluminium, der dielektrischen Schicht und der Oberfläche des darunterliegenden, zu kontaktierenden Siliciummaterials, woraus bevorzugt die Halbleiterschicht besteht, gebildet wird, ohne dass der Wärmeeintrag in dem zu kontaktierenden Halbleitermaterial derart groß wird, dass eine Diffusion von Dotierstoff aus einer nachfolgenden Halbleiterschicht, beispielsweise dem Emitters der Solarzelle, einsetzen kann oder die Passivierungswirkung der dielektrischen Schicht herabgesetzt wird.
Erfindungsgemäß bildet sich demzufolge ein räumlich sehr eng begrenzter Kontaktbereich aus, der außer zur elektrischen Kontaktierung zwischen der Metall und der Halbleiterschicht, die durch die dielektrische Schicht voneinander getrennt sind, keine weitere Tiefenerstreckung in den Halbleiterbereich aufweist.
Eine notwendige Voraussetzung hierfür ist, die unter der Passivierungsschicht befindliche Halbleiteroberfläche möglichst wenig durch den Energieeintrag aufzuschmelzen, wodurch gleichzeitig eine geringe Kontakttiefe von wenigen Mikrometem (<20µm) erreicht wird.

Als Lichtquelle, wird wie bereist erwähnt ein Laser eingesetzt, der vorzugsweise gepulst betrieben wird und die Kontaktstellen auch mehrfach mit geeigneten Energiedichten bestrahlt. Besonders eignen sich Lichtpulse mit einer Pulsdauer, die zwischen einer und 500 Nanosekunden liegt, um die thermische Belastung der an den Kontaktbereich angrenzenden Materialschichten möglichst gering zu halten und damit deren Eigenschaften, insbesondere die Passivierungswirkung der dielektrischen Schicht zu erhalten, aber gleichzeitig die thermische Einwirkung lang genug aufrechtzuerhalten bzw. oft genug zu wiederholen, um das Aufschmelzen der Oberfläche des Siliciums zu gewährleisten, um hierdurch einen sehr guten elektrischen Kontakt entstehen zu lassen. Das lokale Erstarren der Schmelzmischung kann dabei so erfolgen, dass sich an der Oberfläche des zu kontaktierenden Halbleiters zuerst eine Schicht aus aluminiumdotiertem Silicium bildet und darauf der eigentlich Aluminiumkontakt entsteht. Die lokale Dotierung hat den Vorteil, dass der spezifische Kontaktwiderstand reduziert und das durch die Dotierung erzeugte elektrische Feld die Rekombinationsrate an der Metall-Silicium-Grenzfläche herabgesenkt wird.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnung exemplarisch beschrieben. Es zeigen:
- Fig. 1: Solarzelle nach dem Stand der Technik,
- Fig. 2: optimierte Solarzelle mit Passivierungsschicht nach dem Stand der Technik
- Fig. 3: Lokales Aufschmelzen der Metallschicht, der darunterliegenden Passivierungschicht und der Oberfläche der Siliciumschicht
- Fig. 4: Apparatur zur Regelung des Kontaktienrngsprozesses und
- Fig. 5: Laserscanner zur industriellen Umsetzung des Kontaktierungsverfahrens der vorliegenden Erfindung

### Wege zur Ausführung der Erfindung, gewerbliche Verwendbarkeit

In den Figuren 1 und 2 sind jeweils bekannte Solarzellen dargestellt, die in der Beschreibungseinleitung zur Würdigung des Standes der Technik beschrieben worden sind. Insbesondere die in Figur 2 dargestellte Solarzelle, die aus Gründen der Optimierung auf der Rückseite eine Passivierungsschicht sowie intrinsische Effekte zur Vermeidung von Oberflächenrekombinationen von Ladungsträgern vorsieht, gilt es bevorzugt mit dem erfindungsgemäßen Verfahren auf eine möglichst kostengünstige und sichere Weise herzustellen. Die Passivierungsschicht 7 spielt bei den Ausführungen eine zentrale Rolle, da sie ein wesentliches Merkmal des betrachteten Solarzellentypus darstellt und in ihrer Funktion, nämlich der Herabsetzung der Oberflächenrekombination und somit der Vermehrung der zum Stromfluss beitragenden Ladungsträger, nicht wesentlich durch den Kontaktierungsprozess beeinträchtigt werden darf.

Nach Fertigstellung der Solarzellenvorderseite, wird auf der Solarzellenrückseite zunächst eine passivierende, dünne Schicht aus siliziumreichem Siliziumnitrid mit typischer Weise einer Dicke von etwa 60 nm aufgebracht. Unter Bezugnahme auf die Figur 2 ist dies die Schicht 7, die als Passivierungsschicht dient. Das Siliziumnitrid wird anschließend bei ca. 400°C in einer Formiergas-Atmosphäre verdichtet, um die Passivierungseigenschaften zu verbessern und zu konservieren.

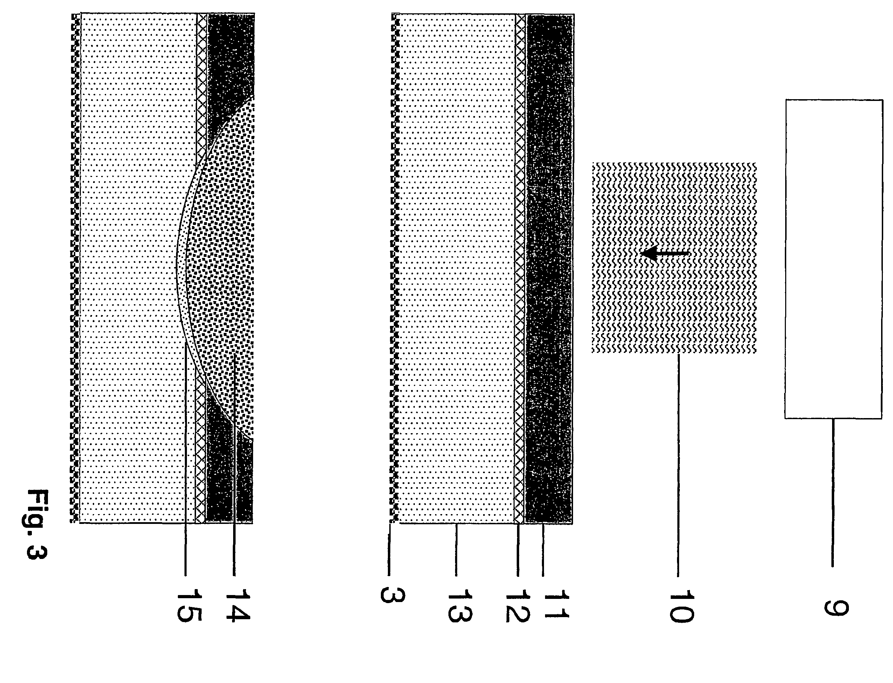

Als nächster Schritt wird auf die Passivierungsschicht eine typischervveise 2 µm starke ganzflächige Metallschicht aus Aluminium aufgebracht. Einen derartigen Schichtaufbau zeigt das obere Ausführungsbeispiel gemäß Figur 3, das einen Teilquerschnitt einer Solarzelle mit der Rückseite nach oben liegend zeigt sowie mit der vorderseitig bereits den Emitter 3 tragenden Si-Halbleiterschicht 13, der darauf befindlichen Passivierungsschicht 12 sowie schließlich einer auf der Passivierungsschicht 12 befindlichen Aluminiumschicht 11.

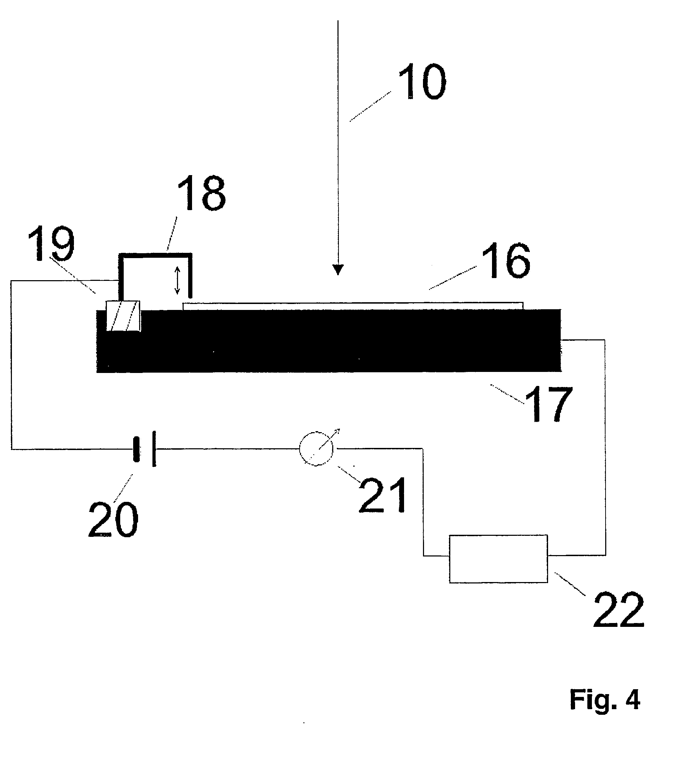

Mit der das Kontaktgrid tragenden Vorderseite nach unten auf dem in Figur 4 dargestellten Messblock 17 liegend, auf den an einer späteren Stelle näher eingegangen wird, wird die rückseitig derart beschichtete Solarzelle unter die in Figur 3 schematisch dargestellte Lichtquelle 9 gebracht, die punktförmige Lichtpulse 10 mit kurzer Pulslänge im ns-Bereich zu erzeugen vermag.

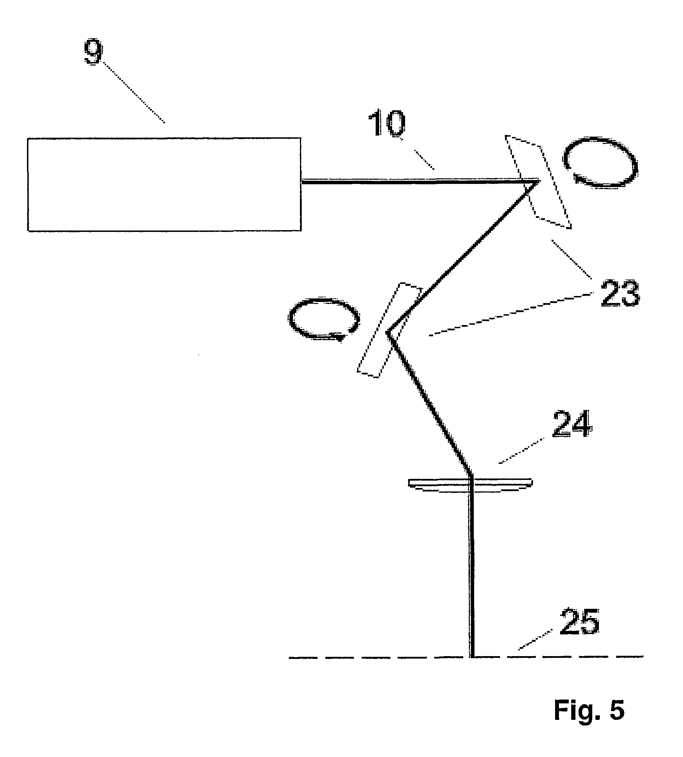

Die Lichtquelle 9 ist vorzugsweise in ein in Figur 5 dargestelltes System mit drehbaren Spiegeln 23 integriert, die kurz aufeinanderfolgende Lichtpulse 10 über eine Brennlinse 24 mit hoher Geschwindigkeit an verschiedenen Orten auf der Solarzellenrückseite, die sich in der Brennebene 25 befindet, positionieren, so dass es möglich wird alle über die gesamte Rückseite verteilten Kontaktstellen in wenigen Sekunden einmal zu prozessieren. Bei geeigneter Wahl der Laserparameter bildet sich nach einer bzw. mehreren Prozesswiederholungen über alle Kontaktstellen ein ausreichend guter elektrischer Kontakt zwischen Metallschicht 11 und Halbleiterschicht 13 aus.

Während der Prozessierung wird über einen senkrecht zur Solarzellenoberfläche beweglichen, durch eine lsolationsummantelung 19 vom Messblock 17 elektrisch getrennten Kontaktfinger 18 ein elektrischer Stromkreis zwischen der ganzflächigen Rückseitenmetallisierung der Solarzelle 16, den Kontaktfingern 18, der Spannungsquelle 20, dem Strommessgerät 21, der Laserleistungsregelung 22, dem Messblock 17 und dem Vorderseitengrid der Solarzelle 16 geschlossen. Nach Einprägen einer vorgegebenen Spannung durch die Spannungsquelle 20 in die Solarzelle 16, durch die aufgrund der Nichtleitfähigkeit der dielektrischen Schicht 12 vor Ausbildung des Rückseitenkontakts durch den vorstehend beschriebenen Schichtaufbau zunächst kein Strom fließt, beginnt die punktförmige Lichtquelle 10 das oben beschriebene Kontaktierungsverfahren zu realisieren. Erst nachdem sich durch das oben beschriebene Kontaktierungsverfahren ein ausreichend guter elektrischer Kontakt zwischen Metallschicht 11 und Halbleiterschicht 13 durch die dielektrische Schicht 12 hindurch ausgebildet hat, fließt ein durch die eingeprägte Spannung vorbestimmter elektrischer Strom durch das Strommessgerät 21, woraufhin die Laserleistungsregelung 22 den Kontaktierungsprozess abbricht. Auf diese Weise kann ein definierter Energieeintrag in das zu bearbeitende Schichtgefüge eingebracht werden, wobei die Wärmebelastung der unter der dielektrischen Schicht liegenden, zu kontaktierenden Halbleiteroberfläche sowie der dielektrischen Schicht in der Umgebung der Lichtdeposition ausreichend klein gehalten werden kann.

Dennoch können die dielektrische Schicht 12 sowie die Oberfläche der Si-Halbleiterschicht 13 durch die Lichtpulse 10 der Lichtquelle 9 zur Ausbildung eines elektrischen Kontakts zwischen Si-Halbleiterschicht 13 und Metallschicht 11 im direkten Einwirkbereich der Lichtpulse 10 aufgeschmolzen werden (siehe Figur 3 untere Darstellung). Die Regelung der Laserleistung durch den in Figur 4 dargestellten Messaufbau ermöglicht die exakte, schädigungsarme Prozessführung und verhindert eine nicht gewollte Diffusion aus dem Emitter 3 heraus bis zur Solarzellenrückseite, was einen elektrischen Kurzschluss und somit einer Zerstörung der Solarzelle gleich käme.

In der vorstehenden Weise wird mit exakt geregelter Laserleistung bei einer lokalen Deponierung von Lichtenergie an der Kontaktstelle 14 das Aluminium 11 in Art eines Metallbades derart kontrolliert aufgeschmolzen, dass der Prozess direkt nach Ausbildung einer ausreichend gut elektrisch leitenden Legierung 15 bestehend aus dem sich ausbildenden Aluminiumschmelzbad, der wenige Mikrometer tief aufgeschmolzenen Oberfläche des Siliziums 13 sowie Teilen der Passivierungsschicht 12 beendet wird .

Bei ersten Versuchen der auf diese Weise hergestellten Solarzellen wurde bereits ein hoher Wirkungsgrad von 19,3 % bei ausgezeichnetem Kontaktverhalten erzielt. Eine Prozessierung ohne die genaue Regelung der Laserleistung erweist sich als wenig reproduzierbar und kann zum elektrischen Kurzschluss zwischen dem zu kontaktierenden Basismaterial und der den Emitter tragenden Solarzellenvorderseite führen, entweder durch ein zu weites Eintreiben des Aluminiumschmetzbades oder durch unkontrollierte Diffusion von Dotieratomen aus der Emitterschicht 3 zur der den Kontakt ausbildenden Legierung 15.

Das Verfahren weist also gegenüber dem Stand der Technik mehrere Vorteile auf: Zum einen kann eine Schichtstruktur verwendet werden, die nach heutigem Stand eine deutlich höhere Leistungsfähigkeit der Solarzelle ermöglicht als unter (A) und (B) realisiert. Im Vergleich zu den photolithographischen Verfahren (C) und (D) ist der Herstellungsprozeß deutlich vereinfacht und kann kostengünstiger realisiert werden.

Im Vergleich zu den Verfahren (E) - (H) kann die Materialbeschädigung durch das vergleichsweise schonende Einlegieren des Aluminiums reduziert werden. Auch sind für das reine Aufschmelzen geringere Energien notwendig als für das Abtragen, so dass bei gleicher eingesetzter Gesamtenergie die Prozesszeit reduziert werden kann.
Auch stehen für das Aufschmelzen einer metallischen Oberfläche wesentlich mehr und u.a. effektivere Lasersysteme als für das Abtragen von dielektrischen Schichten zur Verfügung. Da bereits sofort nach dem Aufschmelzen der Kontakt gebildet wird, kann eine Verschmutzung der Umgebung des lokalen Kontaktes durch ablatiertes Material vermieden werden. Das Einlegieren des Aluminiums bildet darüber hinaus die Möglichkeit sehr gute Kontaktwerte zu erreichen und gleichzeitig die Rekombination am Kontakt zu reduzieren. Im Vergleich zu dem Verfahren (1) kann, anstelle der Verwendung kompliziert aufgebauter Pasten, elementares Metall für die Kontaktierung benützt werden. Erfindungsgemäß bietet auch die einfache Prozeßfolge ein hohes Potential zur kostengünstigeren Herstellung. Das kontrollierte nur lokale Erhitzen gibt dazu zusätzliche Möglichkeiten für die Verwendung von thermisch sensiblen Materialien deren Passivierungswirkung durch eine Temperaturerhöhung, wie in Verfahren (I) vorgesehen, nachlässt. Bei Verfahren (I) wird außerdem für die Realisation eines Rückseitenspiegels ein zusätzlicher Prozessschritt notwendig.

Zusammengefasst kann also erfindungsgemäß mit einem vergleichsweise einfachen Herstellungsverfahren ein Rückseitenkontakt realisiert werden, der ein sehr hohes Wirkungsgradpotential aufweist und damit einen deutlichen Vorteil im Vergleich zu den bisher bekannten Varianten realisiert.

### Bezugszeichenliste

- 1: Solarzelle
- 2: Basis-Bereich
- 3: Emitter-Bereich
- 4: Kontaktelektroden
- 5: Rückseitenkontaktfläche
- 6: Metall-Grid
- 7: Antireflexionsschicht, Passivierungsschicht
- 8: Rückseitenkontakte
- 9: Lichtquelle, Laser
- 10: Laserpuls
- 11: Metallfläche
- 12: Passivierungsschicht
- 13: Halbleiter
- 14: Kontakt
- 15: Legierung
- 16: Solarzelle
- 17: Messblock / Hatterungsblock
- 18: Kontaktfinger
- 19: Isolation
- 20: Spannungsquelle
- 21: Strommessgerät
- 22: Laserleistungsregelung
- 23: Drehbare Spiegel
- 24: Fokussierendes Objektiv
- 25: Brennebene

## Patentansprüche

1. Verfahren zur elektrischen Kontaktierung einer, mit wenigstens einer dielektrischen Schicht (12) überzogenen Halbleiterschicht (13), durch lokale Erhitzung mittels Laserstrahlungsenergieeintrag, wobei eine Metallschicht (11) auf die dielektrische Schicht (12) aufgebracht wird
**dadurch gekennzeichnet,**
**dass** mittels eines Lasers (9) diese Metallschicht (11) kurzzeitig lokal punkt- oder linienförmig durch Regelung der Laserstrahlungsenergle derart kontrolliert erhitzt wird, so dass nach Ausbilden einer lokalen Schmelzmischung ausschließlich aus der Metallschicht (11), der dielektrischen Schicht (12) sowie der unmittelbar unter der dielektrischen Schicht (12) befindlichen Oberfläche der Halbleiterschicht (13) das Einbringen der Laserstrahlungsenergie beendet wird, wobei ein Erstarren der Schmelzmischung zu einem elektrischen Kontakt zwischen der Halbleiterschicht (13) und der Metallschicht (11) führt, der durch möglichst geringes Aufschmelzen der unter der dielektrischen Schicht (12) befindlichen Oberfläche der Halbleiterschicht (13) eine geringe kontakttiefe von weningen Mikrometem aufweist, wodurch sowohl die dielektrische Schicht (12) als auch die zu kontaktierende Halbleiterschicht (13) nicht über den Bereich des elektrischen Kontaktes hinaus in ihren Eigenschaften durch Überhitzung während des lokalen thermischen Energieeintrages verändert werden.

2. Verfahren nach Anspruch 1,
**dadurch gekennzeichnet, dass** die Regelung der Laserstrahlungsenergie mit dem Ziel durchgeführt wird, die dielektrische Schicht (12) und die Halbleiterschicht (13) einer möglichst geringen Wärmebelastung durch die eingebrachte Laserstrahlungsenergie auszusetzen.

3. Verfahren nach Anspruch 1 oder 2,
**dadurch gekennzeichnet, dass** durch die Kombination mehrerer kontaktierter Punkte oder Linien eine Fläche kontaktiert wird.

4. Verfahren nach einem der Ansprüche 1 bis 3,
**dadurch gekennzeichnet, dass** der spezifische Kontaktwiderstand durch Einlegieren der Metallschicht (11) in die Oberfläche der Halbleiterschicht (13) unter den kontaktierten Punkten und Linien kleiner als 0,02 Ωcm² ist.

5. Verfahren nach einem der Ansprüche 1 bis 4,
**dadurch gekennzeichnet, dass** die Metallschicht (11) und die Halbleiterschicht (13) ausschließlich durch genau eine dielektrische Schicht (12) voneinander getrennt sind.

6. Verfahren nach einem der Ansprüche 1 bis 5,
**dadurch gekennzeichnet, dass** als Material für die dielektrische Schicht (12) Siliziumnitrid oder Siliziumdioxid verwendet wird.

7. Verfahren nach einem der Ansprüche 1 bis 6,
**dadurch gekennzeichnet, dass** die dielektrische Schicht (12) eine Dicke zwischen 10 und 500 nm aufweist.

8. Verfahren nach einem der Ansprüche 1 bis 7,
**dadurch gekennzeichnet, dass** die Metallschicht (11) aus Aluminium besteht.

9. Verfahren nach einem der Ansprüche 1 bis 8,
**dadurch gekennzeichnet, dass** die Metallschich (11) zwischen 0,5 und 10 µm stark ausgebildet wird.

10. Verfahren nach einem der Ansprüche 1 bis 9,
**dadurch gekennzeichnet, dass** die Metallschicht (11) durch Aufdampfen oder Sputtem hergestellt wird.

11. Verfahren nach den Ansprüchen 1 bis 10,
**dadurch gekennzeichnet, dass** als Halbleiter Silizium verwendet wird.

12. Verfahren nach den Ansprüchen 1 bis 11,
**dadurch gekennzeichnet, dass** als Halbleiter p-dotiertes Silizium mit einem spezifischen Widerstand größer als 0,1 Ωcm² verwendet wird.

13. Verfahren nach Anspruch 8 und 12,
**dadurch gekennzeichnet, dass** die zuvor lokal aufgeschmolzene Oberfläche der Halbleiterschicht (13) nach dem Erstarren eine lokale Dotierung mit Atomen aus der Metallschicht aufweist, welche die gleiche Polarität hat wie die zu kontaktierende Halbleiterschicht (13) und durch deren eingebautes elektrisches Feld die Rekombinationsrate an der Grenzfläche Halbleiter/Legierung herabgesetzt wird.

14. Verfahren nach den Ansprüchen 1 bis 13,
**dadurch gekennzeichnet, dass** der Laser eine Pulslänge im Bereich 1 ns - 500 ns aufweist.

15. Verfahren nach einem der Ansprüche 1 bis 14,
**dadurch gekennzeichnet, dass** die wenigstens eine dielektrische Schicht (12) eine passivierende Schicht ist.

## Claims

1. Method of electrically contacting a semiconductor layer (13) coated with at least one dielectric layer (12), by local heating by means of injection of laser radiation energy, wherein a metal layer (11) is applied on said dielectric layer (12),
**characterised in**
**that** said metal layer (11) is temporarily locally heated in linear or dotted form by means of a laser (9) by control of the laser radiation energy in such a controlled manner that, after the formation of a local molten mixture consisting exclusively of said metal layer (11), said dielectric layer (12) as well as the surface of said semiconductor layer (13) located directly underneath said dielectric layer (12), the injection of laser radiation energy is terminated, with a solidification of said molten mixture leading to an electrical contact between said semiconductor layer (13) and said metal layer (11), which, due to fusion at a minimum possible of the surface of said semiconductor layer (13), which is located directly underneath said dielectric layer (12), presents a slight depth of contact of a few micrometers, so that the characteristics of both said dielectric layer (12) and said semiconductor (13) to be contacted will not be modified beyond the region of said electric contact as a result of overheating during the local injection of thermal energy.

2. Method according to Claim 1,
**characterised in that** the laser radiation energy is controlled with the aim to expose said dielectric layer (12) and said semiconductor layer (13) to a minimum of thermal load by the injected laser radiation energy.

3. Method according to Claim 1 or 2,
**characterised in that** a surface is contacted by the combination of several contacted dots or lines.

4. Method according to any of the Claims 1 to 3,
**characterised in that** the specific contact resistance is smaller than 0.02 Ωcm² on account of said metal layer (11) alloying into the surface of said semiconductor layer (13) under the contacted dots and lines.

5. Method according to any of the Claims 1 to 4,
**characterised in that** said metal layer (11) and said semiconductor layer (13) are separated from each other exclusively by precisely one dielectric layer (12).

6. Method according to any of the Claims 1 to 5,
**characterised in that** silicon nitride or silicon dioxide is used as material for said dielectric layer (12).

7. Method according to any of the Claims 1 to 6,
**characterised in that** said dielectric layer (12) has a thickness between 10 and 500 nm.

8. Method according to any of the Claims 1 to 7,
**characterised in that** said metal layer (11) consists of aluminium.

9. Method according to any of the Claims 1 to 8,
**characterised in that** said metal layer (11) is formed with a thickness between 0.5 and 10 µm.

10. Method according to any of the Claims 1 to 9,
**characterised in that** said metal layer (11) is produced by vapour deposition or sputtering.

11. Method according to any of the Claims 1 to 10,
**characterised in that** silicon is used as semiconductor material.

12. Method according to any of the Claims 1 to 11,
**characterised in that** p-doped silicon with a resistivity higher than 0.1 Ωcm² is used as semiconductor material.

13. Method according to the Claims 8 and 12,
**characterised in that**, after solidification, the previously locally fused surface of said semiconductor layer (13) presents a local doping level with atoms from said metal layer that is of the same polarity as said semiconductor layer (13) to be contacted and that, due to the electric field integrated therein, the recombination rate at the semiconductor/alloy interface is reduced.

14. Method according to any of the Claims 1 to 13,
**characterised in that** the laser has a pulse length in the range from 1 ns to 500 ns.

15. Method according to any of the Claims 1 to 14,
**characterised in that** said at least one dielectric layer (12) is a passivation layer.

## Revendications

1. Procédé à établir un contact électrique avec une couche semi-conductrice (13) revêtue d'au moins une couche diélectrique (12), par chauffage local moyennant l'injection de l'énergie de rayonnement du laser, dans lequel une couche métallique (11) est appliquée sur ladite couche diélectrique (12),
**caractérisé en ce**
**que** ladite couche métallique (11) subit un chauffage local temporaire sous forme en lignes ou pointillée moyennant un laser (9) par commande de l'énergie de rayonnement du laser d'une telle manière contrôlée, que, suivant la formation d'un mélange fondu local consistant exclusivement en ladite couche métallique (11), ladite couche diélectrique (12) ainsi que la surface de ladite couche semi-conductrice (13) disposée directement au-dessous de ladite couche diélectrique (12), l'injection de l'énergie de rayonnement du laser est terminée, à la solidification dudit mélange fondu fournissant un contact électrique entre ladite couche semi-conductrice (13) et ladite couche métallique (11), qui, en vertu de la fusion à un minimum possible de la surface de ladite couche semi-conductrice (13), qui se trouve directement au-dessous de ladite couche diélectrique (12), présente une petite profondeur de contact de quelques micromètres, de telle manière, que les caractéristiques de ladite couche diélectrique (12) et dudit semi-conducteur (13) à contacter ne soient pas modifiées au-delà de la zone du contact électrique en conséquence de surchauffage au cours de l'injection locale de l'énergie thermique.

2. Procédé selon la revendication 1,
**caractérisé en ce que** l'énergie de rayonnement du laser est commandée dans le but d'exposer ladite couche diélectrique (12) et ladite couche semi-conductrice (13) à un minimum de charge thermique par l'énergie injectée de rayonnement du laser.

3. Procédé selon la revendication 1 ou 2,
**caractérisé en ce qu'**une surface est contactée par la combinaison de plusieurs points ou lignes.

4. Procédé selon une quelconque des revendications 1 à 3,
**caractérisé en ce que** la résistance de contact spécifique est inférieure à 0,02 Ωcm² en vertu de ladite couche métallique (11) entrant en alliage dans la surface de ladite couche semi-conductrice (13) au-dessous des points et lignes contactés.

5. Procédé selon une quelconque des revendications 1 à 4,
**caractérisé en ce que** ladite couche métallique (11) et ladite couche semi-conductrice (13) sont séparées l'une de l'autre exclusivement par précisément une couche diélectrique (12).

6. Procédé selon une quelconque des revendications 1 à 5,
**caractérisé en ce que** du nitrure de silicium ou du dioxyde de silicium est employé en tant que le matériau pour ladite couche diélectrique (12).

7. Procédé selon une quelconque des revendications 1 à 6,
**caractérisé en ce que** ladite couche diélectrique (12) a une épaisseur entre 10 et 500 nm.

8. Procédé selon une quelconque des revendications 1 à 7,
**caractérisé en ce que** ladite couche métallique (11) consiste en aluminium.

9. Procédé selon une quelconque des revendications 1 à 8,
**caractérisé en ce que** ladite couche métallique (11) est formée en une épaisseur entre 0,5 et 10 µm.

10. Procédé selon une quelconque des revendications 1 à 9,
**caractérisé en ce que** ladite couche métallique (11) est produite par dépôt à vapeur ou pulvérisation cathodique

11. Procédé selon une quelconque des revendications 1 à 10,
**caractérisé en ce que** du silicium est employé en tant que matériau semi-conducteur

12. Procédé selon une quelconque des revendications 1 à 11,
**caractérisé en ce que** du silicium dopé en P, à une resistivity plus haute que 0,1 Ωcm², est employé en tant que matériau semi-conducteur

13. Procédé selon les revendications 8 et 12,
**caractérisé en ce qu'**après la solidification, la surface de ladite couche semi-conductrice (13), qui était mise en fusion locale auparavant, présente un niveau de dopage local aux atomes à partir de ladite couche métallique, qui est de la même polarité que ladite couche semi-conductrice (13) à contacter, et **en ce qu'**en vertu du champ électrique y intégré, la vitesse de recombinaison à l'interface semi-conducteur/alliage est réduite.

14. Procédé selon une quelconque des revendications 1 to 13,
**caractérisé en ce que** le laser a une longueur d'impulsions dans la gamme entre 1 ns et 500 ns.

15. Procédé selon une quelconque des revendications 1 à 14,
**caractérisé en ce qu'**au moins une couche diélectrique (12) est une couche de passivation.
